# EUROPÄISCHE PATENTANMELDUNG

(11) **EP 4 717 681 A1**
(43) Veröffentlichungstag der Anmeldung: **01.04.2026**
(21) Anmeldenummer: 24203101.1
(22) Anmeldetag: 27.09.2024
(51) Int. Cl.: C03B 19/02

(54) **GLASRING AUS MULTIKOMPONENTENGLAS SOWIE VERFAHREN UND VORRICHTUNG ZUR HERSTELLUNG DESSELBEN**

(71) Anmelder: Heraeus Quarzglas GmbH & Co. KG, 63450 Hanau (DE)
(72) Erfinder: Schenk, Christian, 63450 Hanau (DE); König, Markus, 63450 Hanau (DE); Wentzel, Michael, 63450 Hanau (DE)
(74) Vertreter: Heraeus IP

(57) **Zusammenfassung**

Eine Aufgabe der Erfindung ist die Herstellung von endgeometrienahen Ringen aus einem Multikomponentenglas, und zwar insbesondere von dickwandigen Ringen mit Wandstärken von mehr als 10mm. Dafür wird zunächst ein ringförmiger Rohling aus dem Multikomponentenglas anhand eines Gießvorgangs erzeugt, bei dem ein Gießstrang aus einer Glasschmelze des Multikomponentenglases in eine Gießform mit einem um eine Mittelachse umlaufenden, ringförmigen Gießraum eingelassen wird. Der auf eine Auftreffzone auftreffende Gießstrang divergiert dabei in einen rechten Teilstrom und in einen linken Teilstrom, wobei die Teilströme an einer Vereinigungszone im Gießraum zusammenfließen und dabei den Gießraum mindestens über einen Teil seiner Höhe auffüllen. Nach dem Abkühlen der Glasschmelze wird ein ringförmiger Rohling erhalten, der zum Glasring aus dem Multikomponentenglas weiterarbeitet wird.

## Beschreibung

### Technischer Hintergrund

Die Erfindung betrifft ein Verfahren zur Herstellung einer Glasrings aus Multikomponentenglas, insbesondere von großformatigen, vorzugsweise dickwandigen Glasringen.

Außerdem betrifft die Erfindung eine Vorrichtung zur Herstellung eines Glasrings aus Multikomponentenglas.

Außerdem betrifft die Erfindung einen Glasring aus Multikomponentenglas.

Derartige Glasringe werden beispielsweise bei der Halbleiterfertigung als sogenannte "Plasmaätzringe" zur Halterung von Halbleiter-Wafern in Plasmaätzanlagen eingesetzt.

Plasmaunterstützte Fertigungsverfahren, wie beispielsweise plasmaunterstütztes Trockenätzen - auch kurz als "Plasmaätzen" bezeichnet - ist eine Technologie zum Herstellen ultrafeiner Strukturen von Halbleiterbauelementen, hochauflösender Displays und in der Solarzellenfertigung. Das Plasmaätzen wird in einer mit Ätzgas unter geringem Druck gespülten Plasmakammer ausgeführt, in der ein reaktives, ätzaktives Plasma erzeugt wird. Zum Ätzen von Strukturen auf Siliziumbasis werden üblicherweise halogenhaltige Ätzgase eingesetzt, wie beispielsweise CF₄, C₂F₆, C₃F₈, C₄F₆, CH₂F₂, C₄F₈, NF₃, SF₆, HF, HCl oder HBr. Die Komponenten der Plasmakammer werden von Zeit zu Zeit gereinigt, was in der Regel ebenfalls mittels Plasmas und fluorhaltigem Ätzgas erfolgt.

### Stand der Technik

Die dem Plasma und dem Ätzgas ausgesetzten Ringe bestehen häufig aus Quarzglas und werden auch als Ätzringe bezeichnet. Für deren Herstellung wird gemäß der EP 3 656 746 A1 ein Zwischenprodukt in Form eines Hohlzylinders aus synthetisch erzeugtem Quarzglas erzeugt, aus dem anschließend die Ätzringe geschnitten werden.

Synthetisch erzeugtes Quarzglas zeichnet sich durch hohe Reinheit, UV-Transparenz, chemische Beständigkeit gegenüber vielen im Fertigungsprozess eingesetzten Substanzen sowie hohe Temperaturbeständigkeit aus. Allerdings erodiert Quarzglas durch Plasma in Gegenwart von halogenhaltigem, insbesondere von fluorhaltigem Ätzgas, und infolge der Erosion kommt es zu einer Erhöhung der Oberflächenrauheit des Quarzglases und zu einer verstärkten Partikelbildung im Fertigungsprozess.

Es ist bekannt, dass Multikomponentengläser, die zusätzlich zu SiO₂ mehrere andere Komponenten, insbesondere Seltenerdmetall-Verbindungen, enthalten, eine erhöhte Trockenätzbeständigkeit aufweisen können. So wird in der US 6,887,576 B2 vorgeschlagen, die Trockenätzbeständigkeit von Quarzglas durch Dotierung mit Elementen zu erhöhen, die in der Lage sind, mit Fluor zu reagieren und eine Fluoridverbindung zu bilden, deren Siedepunkt höher ist als der von SiF₄. Als Beispiele für diese Elemente werden genannt: Al, Sm, Eu, Yb, Pm, Pr, Nd, Ce, Tb, Gd, Ba, Mg, Y, Tm, Dy, Ho, Er, Cd, Co, Cr, Cs, Zr, In, Cu, Fe, Bi, Ga und Ti.

Aus der US 2014/0274653 A1 sind seltenerdoxidhaltige, Yttriumoxid-haltige Multikomponentengläser bekannt, die sich im Vergleich zu Quarzglas durch höhere Erosionsbeständigkeit gegenüber Plasmaerosion auszeichnen. Die chemische Zusammensetzung dieser plasmabeständigen Multikomponentengläser wird dabei wie folgt spezifiziert:

| | | | |
|---|---|---|---|
| Yttriumoxid (Y₂O₃): | 5 Gew.-% | bis | 40 Gew.-% |
| Aluminiumoxid (Al₂O₃) | 5 Gew.-% | bis | 30 Gew.-% |
| Siliziumdioxid (SiO₂): | 10 Gew.-% | bis | 80 Gew.-% |
| Magnesiumoxid (MgO) | 1 Gew.-% | bis | 20 Gew.-% |

### Technische Aufgabe

Multikomponentengläser werden in der Regel durch Einschmelzen pulverförmiger Rohstoffe erzeugt und haben daher herstellungsbedingt eine geringere Reinheit als Gläser, die "synthetisch" erzeugt werden können, beispielsweise durch Abscheidung der glasbildenden Komponenten aus der Gasphase. Insbesondere kann Multikomponentenglas je nach Reinheit der eingesetzten Rohstoffe Verunreinigungen enthalten, die bei der Halbleiterfertigung schädlich sind.

Plasmabeständige seltenerdoxidhaltige Multikomponentengläser wie auch andere technische Spezialgläser haben außerdem häufig eine ausgeprägte Kristallisationsneigung. Beim Plasma-Trockenätzprozess führen Kristalle, Poren und andere Inhomogenitäten des Glases jedoch zu Partikelbildung. Um eine Kristallisation zu vermeiden, wird beispielsweise zur Herstellung von Bauteilen aus den in der US 2014/0274653 A1 beschriebenen, plasmabeständigen Multikomponentengläsern vorgeschlagen, eine Mischung der Ausgangskomponenten aufzuschmelzen und diese Schmelze anschließend abzuschrecken, oder zunächst ein Multikomponentenglas zu erschmelzen, dieses zu einem Pulver zu zerkleinern und das Pulver bei einer Temperatur unterhalb der Temperatur, bei denen das Glas aufschmelzen würde, zu sintern.

Glas ist jedoch grundsätzlich ein schlechter Wärmeleiter, so dass ein ausreichend schnelles Abschrecken von hoher Temperatur ohne Kristallbildung nur bei kleinen Wandstärken gelingt. Dickwandige Ringe mit Wandstärken von 10mm und mehr sind auf diese Weise kaum herstellbar. Beim Sintern von Glaspulver bei Temperaturen unterhalb der Schmelztemperatur verbleiben Restporen im Sinterkörper, so dass ein transparentes und porenfreies Multikomponentenglas nicht erhalten wird. Zudem ist durch die hohe spezifische Oberfläche von Glaspulvern die Kristallisation bei erhöhter Temperatur ein besonders kritischer Effekt.

Der Erfindung liegt insbesondere die Aufgabe zugrunde, ein Verfahren anzugeben, das die Herstellung von endgeometrienahen Ringen aus einem Multikomponentenglas ermöglicht, und zwar auch bei dickwandigen Ringen mit Wandstärken von mehr als 10mm.

Der Erfindung liegt alternativ oder ergänzend dazu die Aufgabe zugrunde, ein Gießverfahren für Glasringe bereitzustellen, das eine ausreichend hohe Abkühlrate mit einer damit einhergehenden möglichst geringen und im besten Fall ausbleibenden Kristallbildung ermöglicht, und zwar auch bei dickwandigen Glasringen mit Wandstärken von mehr als 10mm.

Außerdem liegt der Erfindung die Aufgabe zugrunde, eine Vorrichtung zur Durchführung des Verfahrens bereitzustellen.

Darüber hinaus ist es Aufgabe der Erfindung, einen dickwandigen Ring aus einem Multikomponentenglas bereitzustellen, der weitgehend frei von Störstellen, wie etwa Blasen, Einschlüssen und Kristallen ist.

### Allgemeine Beschreibung der Erfindung

Hinsichtlich des Verfahrens wird diese Aufgabe durch ein Verfahren mit den Merkmalen von Anspruch 1 gelöst.

Das Verfahren dient zur Herstellung eines Glasrings aus einem seltenerdoxidhaltigen Multikomponentenglas durch Gießen einer Glasschmelze des Multikomponentenglases in eine Gießform.

In einem Schmelzaggregat, beispielsweise in einer Glasschmelzwanne oder in einem Schmelztiegel, wird eine Glasschmelze aus dem Multikomponentenglas erzeugt. Zur Kristallisation neigende Gläser - wie die hier maßgeblichen Multikomponentengläser - müssen auf eine hinreichend hohe Schmelztemperatur erhitzt werden, um eine homogene Schmelze zu erhalten, Kristalle aufzuschmelzen und/oder um eine Keimbildung in der Glasschmelze zu vermeiden. Die Schmelztemperatur bewirkt in der Regel eine niedrige Viskosität der Glasschmelze, was deren Verarbeitung im Gießprozess grundsätzlich erschwert. Denn insbesondere beim Gießen niedrigviskoser Gläser kann es leicht zu erzwungener Konvektion, Faltenbildung und Mischungen unterschiedlich heißer Glasschmelze kommen, was eine Schlierenbildung begünstigt. Schlieren sind stoffliche Schwankungen im Material, die zu sichtbaren Brechwertunterschieden im Glas führen.

Bei der Verarbeitung des Multikomponentenglases durch Gießen hat die Glasschmelze vorteilhafterweise eine Viskosität im Bereich von 10¹ dPa s bis 10⁴ dPa s.

Aus dieser niedrigviskosen Glasschmelze werden einer oder auch mehrere Gießstränge gleichzeitig erzeugt.

Infolge der Gravitationskraft besitzt ein frei ausfließender Glasstrang in der Regel eine vertikale Orientierung seiner Strang-Längsachse und gelangt im einfachsten und bevorzugten Fall unmittelbar auf eine Auftreffzone, die entweder innerhalb des Gießraums liegt oder die eine fluidische Verbindung zum Gießraum hat. Alternativ dazu kann der Gießstrang mittels eines Ablenkelements, wie beispielsweise einer Zuführrinne oder eines Zuführrohres der Auftreffzone auch mit anderer Orientierung der Strang-Längsachse zugeführt werden.

Insbesondere im Hinblick auf ein schnelles Auffüllen des Gießraums mit möglichst geringer Schlierenbildung und Kristallisation wird der Gießstrang nach dem Abfließen von der Auftreffzone in einen rechten Teilstrom und in einen linken Teilstrom aufgeteilt.

Durch diese Aufteilung wird der Fließweg halbiert, der für das Schließen des Rings beziehungsweise zum Auffüllen der Gießraum erforderlich ist. Damit einhergehend wird auch die Fließdauer halbiert oder mindestens verringert. Dies trägt dazu bei, dass die beiden Teilströme eine etwa gleiche thermische Vorgeschichte und Oberflächentemperatur haben; und zwar insbesondere auch dann wenn sie an der Vereinigungszone zusammentreffen.

Die Aufteilung des Gießstrangs in die beiden Teilströme wird im einfachsten und bevorzugten Fall innerhalb des Gießraums bewirkt. Dabei trifft der Gießstrang auf die Gießraum-Innenwand auf und teilt sich in den rechten und linken Teilstrom. Die Teilströme umfließen die Innenwand des Gießraums, kühlen dabei ab und treffen in der Vereinigungszone wieder zusammen. Im Bereich des Zusammenfließens der Teilströme bildet sich eine charakteristische prozessbedingte Schliere aus, die im Folgenden auch als "Gießschliere" bezeichnet wird. Diese Gießschliere kann als Positionierungsmarkierung dienen. Dies ist hilfreich für Anwendungen, bei denen beispielsweise eine vorgegebene Umfangsposition des Glasrings einzuhalten ist, oder für Anlagen, bei denen nach einem Ausbau derselbe Glasring wieder an gleicher Stelle mit der gleichen Positionierung einzubauen ist.

Das dünnflüssige Multikomponentenglas kühlt bei Kontakt zu den Wandungen des Gießraums schnell ab und erstarrt. Dies gilt sowohl für die Seitenwandungen des Gießraums, jedoch insbesondere für den Gießraumboden. Vorteilhafterweise werden die Zufuhr an Glasschmelze und eine etwaige Neigung des Gießraumbodens so aufeinander abgestimmt, dass die beiden Teilströme den Gießraum möglichst vollständig ausfüllen und sowohl den Gießraumboden bedecken als auch Kontakt haben zu den Seitenwänden des Gießraums. Das Auffüllen des Gießraums geschieht gegebenenfalls dadurch, dass sich eine Schmelzwalze, die sich bevorzugt über die gesamte Breite des Gießraums erstreckt, kontinuierlich und mit etwa konstanter Geschwindigkeit über bereits erstarrte Schmelze ähnlich einer Lawine hinwegbewegt. Dabei trägt die wärmeisolierende Wirkung des bereits erstarrten Multikomponentenglases zur Aufrechterhaltung einer hohen Temperatur und einer niedrigen Viskosität der Glasschmelze bei, so dass sich die Schmelzwalze trotz gleicher anfänglicher Viskosität immer weiter in Richtung der Vereinigungszone fortbewegen kann. Wenn der Gießraumboden vollständig mit erstarrter Glasschmelze bedeckt ist, kann dies zu einer Beschleunigung der Bewegungsgeschwindigkeit der Schmelzwalze führen. Zur Anpassung der Bewegungsgeschwindigkeit der Schmelzfront kann die Neigung des Gießraumbodens gegenüber der Horizontalen während des Gießvorgangs verändert werden.

Die Auftreffzone, die Vereinigungszone und die Mittelachse der Gießform liegen vorzugsweise auf einer Linie .

Insbesondere im Hinblick auf geringe Schlierenbildung und Kristallisation hat es sich bewährt, wenn die Auftreffzone auf einer oberen Höhenebene E1 liegt und die Vereinigungszone auf einer unteren Höhenebene E2 liegt.

Dabei ist der Gießraumboden der Gießform während des Gießvorgangs mindestens zeitweise gegenüber der Horizontalen so geneigt, dass die Glasschmelze von einem Auftreffpunkt in der oberen Höhenebene E1 im Gießraum zu der Vereinigungszone einer unteren Höhenebene E2 abfließen kann. Von der Auftreffzone in der oberen Höhenebene E1 ausgehend füllt der Gießstrang den Gießraum allmählich auf. Die Neigung kann das Auffüllen des Gießraums mit der Glasschmelze beschleunigen.

Nach dem Abkühlen der Glasschmelze kann ein ringförmiger Rohling aus dem Multikomponentenglas aus der Gießform entnommen werden. Aus diesem wird durch Weiterverarbeitung der Glasring in den finalen Produktabmessungen erhalten. Die Weiterverarbeitung kann beispielsweise eine thermische Behandlung zur Beseitigung mechanischer Spannungen und/oder eine mechanische Bearbeitung durch Schneiden, Schleifen oder Polieren umfassen.

Die Auftreffzone liegt auf einer oberen Höhenebene E1, die höher liegt als die untere Höhenebene E2, in der sich die Vereinigungszone befindet, so dass zwischen diesen beiden Zonen in den Höhenebenen E1 und E2 ein Neigungswinkel gegenüber der Horizontalen entsteht, der beispielsweise im Bereich von1° bis 30° liegt. Dadurch kann die Glasschmelze im Gießraum nach unten von der Auftreffzone zur Vereinigungszone abfließen. Die Auftreffzone kann mit dem Gießraum fluidisch verbunden sein und liegt beispielsweise innerhalb des Gießraums. Die Vereinigungszone liegt besonders bevorzugt im Gießraum.

In dem Zusammenhang hat es sich als günstig erweisen, wenn die Gießform so orientiert wird, dass der Gießraumboden eine Neigung gegenüber der Horizontalen zwischen den Höhenebenen E1 und E2 aufweist, wobei die Neigung während des Gießvorgangs verändert wird.

Der Höhenunterschied zwischen den Höhenebenen E1 und E2 kann erzeugt werden durch eine gegenüber der Horizontalen geneigte Orientierung der gesamten Gießform im Raum und/oder durch eine konstruktive Ausgestaltung des Gießraumbodens mit einer abfallenden Rampe oder mit mehreren abfallenden Rampen. Der Höhenunterschied kann während des Gießvorgangs konstant bleiben, bevorzugt wird er aber während des Gießvorgangs variiert. Bei einer bevorzugten Verfahrensvariante ist zu Beginn des Gießvorgangs ein größerer Neigungswinkel eingestellt, der mindestens zeitweise während des Gießvorgangs verringert wird.

Der Gießraumboden ist im einfachsten Fall im Querschnitt zwischen den Gießraum-Seitenwänden eben ausgeführt. In einer alternativen Verfahrensweise ist ein Gießraumboden vorgesehen, der zwischen den Gießraum-Seitenwänden mindestens über eine Teilstrecke im Querschnitt U- oder V-förmig ausgebildet ist, so dass er die beiden divergierten Teilströme mittig führt. Dadurch kann der Zeitpunkt verzögert werden, in dem die Glasschmelze die Innenwand oder die Außenwand des Gießraums berührt. Auch in dieser Ausführung weist die Gießform vorzugsweise eine Neigung gegenüber der Horizontalen zwischen den Höhenebenen E1 und E2 auf, wobei die Neigung während des Gießvorgangs verändert werden kann.

Die zeitliche Veränderung der Neigung der gesamten Gießform gegenüber der Horizontalen erfolgt vorzugsweise mittels eines gesteuerten oder geregelten Mechanismus. Die Neigung wird im Verlauf des Gießvorgangs vorzugsweise verringert.

Die Neigung der Gießform wird bevorzugt so gesteuert, dass ein Aufstauen der Glasmasse insbesondere im Bereich der Auftreffzone verhindert wird und dass eine störungsarme Vereinigung der Glasstränge im Bereich der Vereinigungszone erreicht wird. Dafür hat sich eine Neigung von beispielsweise im Bereich von 1 bis 30 Winkelgraden als vorteilhaft gezeigt. Eine permanente Neigung kann zu einer inkonstanten Höhe des Glasrings führen, so dass der gebildete Glasring im Bereich der Vereinigungszone höher ist als im Bereich der Auftreffzone. Durch allmähliche Verringerung der Neigung - eventuell bis zum Erreichen der horizontalen Lage vor Beendigung des Gießvorgangs - kann das in der Regel unerwünschte unterschiedliche Höhenniveau jedoch egalisiert werden.

Die Veränderung der Neigung der Gießform wird üblicherweise beendet, wenn die horizontale Orientierung des Gießraumbodens erreicht ist. Die Geschwindigkeit, mit der die Neigung der Gießform verändert wird, ist vorzugsweise konstant; sie kann aber auch veränderlich sein. Insbesondere kann die Geschwindigkeit zu Beginn des Gießvorgangs höher sein als am Ende. Bevorzugt wird die Neigung der Gießform erst nach der erstmaligen Vereinigung der beiden Teilströme verändert.

Die variable Neigung der Gießform, insbesondere des Gießraumbodens, erleichtert eine störungsarme Vereinigung der Glasstränge in der Vereinigungszone.

In dem Zusammenhang hat sich auch als vorteilhaft erwiesen, wenn die Position der Auftreffzone während einer ersten Gießphase veränderlich ist. Zu Beginn liegt sie bevorzugt auf einer von außen nach innen - in Richtung der Gießraum-Innenwand - abfallenden Rampe. Während einer zweiten Gießphase wird die Position der Auftreffzone auf der Rampe verändert und dabei bevorzugt nach außen - in Richtung weg von der Gießraum-Innenwand - verlagert.

Die Rampe kann sich entlang eines Teillänge des Außenumfangs des Gießraums erstrecken. Sie ist beispielsweise in der Draufsicht von oben keilförmig ausgebildet, wobei die Fläche der Keilform - quer zur Gefällerichtung - entweder gerade ist oder eine Krümmung aufweisen kann. Die Rampe kann als Teil des Gießraums beziehungsweise des Gießraumbodens angesehen werden. Sie bewirkt eine höheres Gefälle im Bereich der Auftreffzone. Damit wird die Glasschmelze beim Auftreffen unter einem Winkel abgelenkt, der größer als der Neigungswinkel des übrigen Gießraumbodens aber kleiner als 90° ist, was das Abfließen der Glasschmelze von der Auftreffzone ausunterstützt. Das Gefälle der Rampe kann mit einem "Rampenwinkel" beschrieben werden, wobei der mittlere Rampenwinkel vorzugsweise im Bereich von 1 bis 60 Grad, bevorzugt im Bereich von 25 bis 45 Grad liegt. Das Gefälle der Rampe ist im einfachsten und bevorzugten Fall konstant. Es kann aber auch eine andere konkave oder konvexe Form in mindestens einer Achse, stets aber monoton fallende Form aufweisen.

Der Gießvorgang kann in mehrere Gießphasen unterteilt werden. Während der ersten Gießphase läuft die Glasschmelze auf dem Formenboden aus und füllt den Bodenbereich aus. In dieser Phase kommt es nicht oder nur in geringem Maße zu einem Höhenaufbau von Glas im Bereich der Auftreffzone. Diese kann an derselben Stelle verbleiben, wobei aber auch oszillierende Hin- und Herbewegungen des Gießstrangs möglich sind. Diese die Auftreffzone oszillierend verlagernden Hin- und Herbewegungen sind klein und liegen typischerweise im Rahmen von 1 bis 10mm.

Das Ende der ersten Gießphase ist beispielsweise gekennzeichnet durch den Zeitpunkt, zu dem sich die divergierten Teilströme erstmals vereinigen, so dass sich die weiterhin fließende Glasschmelze beziehungsweise der Glasring auch in der Höhe aufbaut. Die zweite Gießphase ist somit gekennzeichnet durch die Bewegung der Glasschmelze auch nach oben und dem beginnenden Höhenaufbau des Glasrings. Das heißt, die Glasschmelze läuft auf dem unteren, teilweise abgekühlten Glas in die Gießform und füllt den überwiegenden bzw. gesamten Gießraum auf. Eine vorhandene Neigung der Gießform kann nun reduziert werden (bis zur Horizontalen und eventuell sogar kurzzeitig darüber hinaus), um etwaige Dickenunterschiede aus der ersten Gießphase zu nivellieren, mit dem Ziel der weitgehenden Vergleichmäßigung der Füllhöhe im gesamten Gießraum.

In der zweiten Gießphase kann auch eine relative Bewegung zwischen Gießstrang und Gießform stattfinden, genauer: zwischen der Auftreffzone und dem Gießraum. In der zweiten Gießphase wird beispielsweise die Position der Auftreffzone - vorteilhafterweise auf einer "aufsteigenden Rampe" - in Richtung weg von der Gießraum-Innenwand - nach außen verlagert. Diese Verlagerung der Auftreffzone auf der "aufsteigenden Rampe" nach außen kann von Zeit zu Zeit, vorzugsweise jedoch kontinuierlich erfolgen, vorzugsweise in Richtung einer Verbindungslinie zwischen der Auftreffzone und der Vereinigungszone. Die Geschwindigkeit der Verlagerung auf der aufsteigenden Rampe ist während der zweiten Gießphase konstant oder sie ist variabel, und liegt vorzugsweise im Bereich von 1mm/min bis 100mm/min, vorzugsweise im Bereich zwischen 1 bis 30mm/min.

Die Verbindungslinie zwischen Auftreffzone und Vereinigungszone verläuft vorteilhafterweise durch die Mittellinie des ringförmigen Gießraums. In dem Fall sind rechter und linker Teilstrom gleich lang und die Vereinigungszone befindet sich am tiefsten Punkt des Gießraums in der Ebene E2. Falls sich während des Gießvorgangs die Ausbildung einer Vereinigungszone oberhalb der Ebene E2 abzeichnet, kann dem vorteilhaft entgegengewirkt werden, indem die Auftreffzone relativ zur Gießform verlagert wird. Dabei kann die Auftreffzone in azimutaler Richtung entlang des ringförmigen Gießraum-Umfangs verlagert werden, oder einfacher und daher bevorzugt: durch laterale Bewegung der Gießform senkrecht zur oben genannten Verbindungslinie, oder durch eine Neigung der Gießform um die und entlang der Verbindungslinie (also durch seitliches Verkippen) oder durch Drehen der Form (z.B. um den Mittelpunkt des ringförmigen Gießraums). Bei der relativen Verlagerung der Auftreffzone wird vorteilhafterweise der Höhenabstand zwischen einem Auslass des Glasstrangs und dem Auftreffpunkt konstant gehalten. Das bedeutet beispielsweise für den Fall einer auf einer Rampe mit Gefälle auftreffenden Auftreffzone, dass die relative Verlagerungsbewegung der Auftreffzone der Form (gerade oder gekrümmt) der Rampe in der Verlagerungs-Richtung folgt.

Als "Gießvorgang" wird hier und im Folgenden der gesamte Verfahrensschritt des Gießens der Glasschmelze in die Gießform bezeichnet, der die erste und die zweite Gießphase und gegebenenfalls eine dritte Gießphase umfasst. Unter einer dritten Gießphase können Maßnahmen nach dem vollständigen Befüllen der Gießform zum Beenden des eigentlichen Gießprozesses zusammengefasst werden.

Infolge der Verlagerung der Auftreffzone entlang der aufsteigenden Rampe füllt sich der Gießraum im Verlauf der zweiten Gießphase weiter mit Glasschmelze auf und es kann dazu kommen, dass sich der vertikale Abstand zwischen einem Auslass für den Gießstrang und der Oberfläche der Glasschmelze in der Auftreffzone verkürzt. Um diesen Abstand konstant zu halten, wird die Gießform vorteilhafterweise während der zweiten Gießphase abgesenkt.

Infolge der - vorzugsweise kontinuierlichen - Verlagerung der Auftreffzone und der - vorzugsweise kontinuierlichen - Absenkung der Gießform wird die Glasschmelze von der Auftreffzone ausgehend in den Gießraum so umgelenkt, dass der Meniskus der in den Gießraum einfließenden Glasschmelze trotz des sich ausbreitenden und den Gießraum auffüllenden Schmelzspiegels etwa konstant bleibt.

Die Rampe bildet während des Gießvorgangs in der Regel eine geschlossene Fläche, auf die der Gießstrang auftrifft. Bei einer bevorzugten Verfahrensvariante kann die Rampe aber geöffnet und geschlossen werden und gegebenenfalls mit einer verschließbaren Öffnung ausgestattet. Vor Beginn der Gießraum-Befüllung ist die Öffnung offen, so dass der Gießstrang durch sie hindurch nach unten fällt. Durch Schließen der Öffnung wird der Gießstrang abgeschnitten und von einer vertikalen Fallrichtung von der Rampe in Richtung des Gießraumbodens umgelenkt.

Das Öffnen und Schließen der Öffnung der Rampe erfolgt beispielsweise mittels eines horizontal und in Richtung einer Gießform-Mittelachse radial beweglichen Teils der Rampe, der im Folgenden als "Schieber" bezeichnet wird. Der Schieber kann als Teil einer mehrteiligen Rampe beziehungsweise als Teil einer mehrteiligen Gießform betrachtet werden. Der Schieber ist im geöffneten Zustand der Rampe in einem Abstand zur übrigen Gießform angeordnet und lässt dabei einen "Gießspalt" frei. Der Gießspalt bildet in dem Fall die Öffnung der Rampe. Zu Beginn des Gießvorgangs ist die Rampe (der Gießspalt) geöffnet, und der Gießstrang läuft durch den Gießspalt frei nach unten ab. Dort wird er beispielsweise in einem Gefäß aufgefangen. Durch Heranschieben des Schiebers an die übrige Gießform wird der Gießspalt geschlossen. Der ursprünglich vertikal orientierte Gießstrang wird wie mit einer Schere abgeschnitten, trifft in der Auftreffzone auf die Rampe und fließt danach auf der Rampe weiter in einem Winkel kleiner 90 Grad nach unten ab, wie dies weiter oben anhand der Beschreibung der Rampe näher erläutert ist. Der Schieber bildet im geschlossen Zustand einen Teil der Rampe.

Eine erste vorteilhafte Funktion des Schiebers ist somit das Verschließen des Gießspalts unter Abtrennung des von oben vertikal durch den Gießspalt abfließenden Glasstrangs. Eine zweite vorteilhafte Funktion des Schiebers ist das Umlenken des Glasstrahls in Richtung der Gießform-Mittelachse, so dass das Auslaufen der Teilströme von der Auftreffzone in Richtung der Vereinigungszone umgelenkt wird. Als hilfreich hat sich ebenfalls erwiesen, wenn der Schieber bei geschlossenem Gießspalt an den Gießraumboden angrenzt und beispielsweise den Umfang des Gießraumbodens tangential berührt.

Der Durchsatz an Glasschmelze wird bevorzugt auf einen Bereich von 150 ml/min bis 3000 ml/min, besonders bevorzugt im Bereich 300 ml/min bis 1500 ml/min, dosiert. Er ist während eines Gießvorgangs vorzugsweise konstant, er kann aber auch variabel sein.

Das erfindungsgemäße Verfahren ist besonders geeignet für eine Verarbeitung von Glasschmelzen mit einer geringen Viskosität. Die Viskosität beim Einspeisen liegt bevorzugt im Bereich von 10 bis 10.000 dPa s, besonders bevorzugt im Bereich von 100 bis 1.000 dPa s.

Durch die einfließende Glasschmelze wird die Gießform im Verlauf des Gießvorgangs erwärmt. Um einem schnellen Abkühlen der Glasschmelze an Wandungen des Gießraums insbesondere zu Beginn des Gießvorgangs entgegenzuwirken, hat es sich als vorteilhaft erwiesen, wenn die Gießform beheizt wird.

Das Temperieren der Gießform hat sich als vorteilhaft erwiesen, um einen hohen Wärmeverlust der Glasschmelze an den Wandungen des Gießraums zu verringern. Die Beheizung erfolgt bevorzugt elektrisch, beispielsweise induktiv, per Strahlungsbeheizung oder mittels Heizpatronen. Die Heiztemperatur richtet sich nach dem Temperatur-Viskositätsprofil des jeweiligen Glases. Sie liegt beispielsweise im Bereich der sogenannten Transformations- oder Glasbildungstemperatur Tg oder niedriger, beispielsweise im Temperaturbereich von Tg-300°C bis Tg. Das Beheizen vermindert die Gefahr einer Rissbildung beim Abkühlen des Glasrings und wirkt sich auf die Fließeigenschaften positiv aus, indem zu schnelles Abkühlen unterhalb Tg verhindert werden kann. Alternativ oder ergänzend dazu ist auch eine thermische Isolation der Gießform vorteilhaft, beispielsweise indem Feuerfestmaterial oberhalb der Gießform platziert wird, oder indem die Glasschmelze in der Gießform aktiv von oben beheizt wird; beispielsweise mittels einer Gasflamme oder eines Porenbrenners.

Bei einer bevorzugten Verfahrensvariante ist die Gießraum-Innenwand und/oder die Gießraum-Außenwand konisch ausgebildet und relativ zum Gießraumboden in vertikaler Richtung beweglich.

Die Innenwand wird beispielsweise von einem absenkbaren Zylinder oder Ring, vorzugsweise einem Konus, gebildet. Im Verlauf der Abkühlung der Glasschmelze kann vorzugsweise der Zylinder/Konus (also die Gießraum-Innenwand) um einige Millimeter vertikal bewegt und somit ein Spalt zwischen dem festen Glaskörper und der Innenwand des Gießraumes erzeugt werden. Im Fall der Innenwand mit Konusform ist es unerheblich, ob der Konus nach oben oder unten verjüngt ist: die vertikale Bewegung während des Abkühlens erfolgt in jedem Fall so, dass der Durchmesser der Innenwand gegenüber dem Innendurchmesser des Glasrings reduziert und so ein Spalt gebildet und damit ein Verkeilen bei der Entnahme des Glasrings aus der Gießform vermieden wird.

Hinsichtlich der Vorrichtung zur Herstellung eines Glasrings aus Multikomponentenglas wird die oben genannte Aufgabe durch eine Vorrichtung mit den Merkmalen von Anspruch 11 gelöst.

Die Vorrichtung umfasst
(a) eine Gießform mit einem um eine Mittelachse umlaufenden, ringförmigen Gießraum mit einer Gießraumhöhe, der einen von Innenwand und Außenwand begrenzten Gießraumboden und diesem gegenüberliegend eine Gießraumöffnung aufweist,
(b) einen Auslauf zum Zuführen einer Schmelze des Glases zu der Gießform, und
(c) eine Bewegungseinheit zur räumlichen Bewegung des Auslaufs und/oder der Gießform.

Die Bewegungseinheit dient dazu, die Gießform an einer vorgegebenen Stelle und/oder in einer vorgegebenen Orientierung in Bezug auf den Auslauf zu positionieren, und/oder die Gießform entlang einer vorgegebenen Bewegungsbahn relativ zum Auslauf zu bewegen. Die dafür erforderlichen Positionierungen und Bewegungen von Gießform beziehungsweise Auslauf werden von der Bewegungseinheit vorzugsweise computergesteuert ausgeführt.

Zu diesem Zweck verfügt die Bewegungseinheit vorzugsweise über Mittel zur Drehung und Verkippung von Komponenten, wie beispielsweise Gelenke und Drehachsen, und sie verfügt über Mittel zur translatorischen Verschiebung von Komponenten in den drei Raumrichtungen x, y, z, wobei hier "z" die Höhenrichtung repräsentieren soll, wie beispielsweise Lineareinheiten.

Diese Vorrichtung verfügt über Verstell-, Kipp-, Dreh- und/oder Verschiebefunktionen. Insbesondere ist es dadurch möglich, einen aus dem Auslauf austretenden Gießstrang so zu positionieren, dass er an einer Auftreffzone auftrifft und von dort in Richtung der Gießraum-Innenwand abfließt, wo er sich in einen rechten Teilstrom und in einen linken Teilstrom aufteilt. Die Teilströme fließen an einer Vereinigungszone im Gießraum zusammen, wie dies oben bei der Beschreibung des erfindungsgemäßen Verfahrens erläutert ist.

Die Auftreffzone liegt vorzugsweise in einer oberen Höhenebene E1 und die Vereinigungszone in einer unteren Höhenebene E2.

Die Vorrichtung ist zur Durchführung des erfindungsgemäßen Verfahrens geeignet. Vorteilhafte Ausgestaltungen der erfindungsgemäßen Vorrichtung ergeben sich aus den Unteransprüchen. Soweit in den Unteransprüchen angegebene Ausgestaltungen der Vorrichtung den in Unteransprüchen zum erfindungsgemäßen Verfahren genannten Verfahrensweisen nachgebildet sind, wird zur ergänzenden Erläuterung auf die obigen Ausführungen zu den entsprechenden Verfahrensansprüchen verwiesen.

Hinsichtlich des Glasrings aus Multikomponentenglas wird die oben angegebene Aufgabe von einem Glasring mit den Merkmalen von Anspruch 16 gelöst.

Dieser Glasring ist anhand des erfindungsgemäßen Verfahrens herstellbar. Die die Innenwand des Gießraums umfließenden und in der Vereinigungszone zusammentreffenden Teilströme bilden im Bereich der azimutalen Position der Vereinigungszone eine Gießschliere, die den Ring-Querschnitt in radialer Richtung teilweise oder vorzugsweise vollständig durchzieht. Die optische Erkennbarkeit der Gießschliere im Glasring wird dadurch verbessert, wenn sie im Multikomponentenglas einen optischen Gangunterschied von mindestens 30nm bewirkt.

Da nur eine einzige Gießschliere im gesamten Ring-Querschnitt vorhanden ist, kann diese als Positionierungsmarkierung dienen. Dies ist hilfreich für Anwendungen, bei denen beispielsweise eine vorgegebene Umfangsposition des Glasrings einzuhalten ist, oder für Anlagen, bei denen nach einem Ausbau ein und derselbe Glasring wieder an gleicher Stelle mit der gleichen Positionierung einzubauen ist.

Das Multikomponentenglas zeichnet sich durch eine hohe Reinheit aus, die sich exemplarisch darin ausdrückt, dass Verunreinigungen an Cr, Mn, Fe, Co und Ni und Verbindungen für jedes einzelne dieser Elemente weniger als 50 Gew.-ppm und besonders bevorzugt weniger als 20 Gew.-ppm beträgt, und dass die Summe der Verunreinigungen an Cr, Mn, Fe, Co und Ni weniger als 100 Gew.-ppm beträgt.

Zudem zeichnet sich das hochreine Multikomponentenglas im Vergleich zu Quarzglas durch eine hohe Trockenätzstabilität beim reaktiven Ionenätzverfahren ("reactive ion etching" - kurz: RIE) aus.

Der Glasring ist daher als Plasmaätzring für die Halterung von Wafern bei der plasmagestützten Trockenätz-Behandlung geeignet. Er hat typischerweise einen Außendurchmesser im Bereich von 300 bis 500mm, eine Wanddicke von mehr als 10mm und eine Höhe, die mindestens 5mm beträgt.

### Definitionen und Messmethoden

Einzelne Begriffe der obigen Beschreibung werden im Folgenden ergänzend definiert. Die Definitionen sind Bestandteil der Beschreibung der Erfindung. Für Begriffe und Messverfahren, die in der Beschreibung nicht speziell definiert sind, ist die Auslegung gemäß der Internationalen Fernmeldeunion (ITU; International Telecommunication Union) maßgeblich. Bei einem Widerspruch zwischen einer der folgenden Definitionen und der übrigen Beschreibung ist das in der übrigen Beschreibung Gesagte maßgeblich.

### Multikomponentengläser

Das Multikomponentenglas besteht aus mindestens drei Komponenten. Es ist im einfachsten und bevorzugten Fall ein rein oxidisches Glas, bei dem alle Anionen aus Sauerstoff-Ionen (O²⁻) bestehen. Die Sauerstoff-Ionen besetzen gegebenenfalls 100% der Anionenplätze der Netzwerkstruktur des Glases. Bei einer anderen, gleichermaßen bevorzugten Ausführungsform ist ein Teil der Sauerstoff-Ionen durch Fluor-Ionen substituiert. In diesem Fall weist das Multikomponentenglas eine Netzwerkstruktur mit Anionenplätzen auf, wobei
(100-x)% der Anionenplätze durch Sauerstoff-Ionen (O²⁻) und der Anteil x(%) durch Fluor-Ionen (F⁻) besetzt ist, wobei x der Substitutionsgrad (in %) ist und im Bereich zwischen 0,1 und 10 liegt.

### Rampe

Die Rampe kann als Teil des Gießraums und außerdem als Teil der seitlichen Begrenzung der Gießform-Außenwand betrachtet werden. Die Rampe hat ein Gefälle in Richtung der Gießform-Mittellinie und dient dem Umlenken des aus dem Auslaufrohr tretenden Glasstroms, so dass der Glasstrang aus einer vertikalen Ausrichtung auf dem Gießraumboden in Richtung der Gießraum-Innenwand gelenkt wird. Zu diesem Zweck kann die Rampe mit einem verschließbaren Gießspalt ausgestattet sein.

### Viskosität

Die Verarbeitung des Multikomponentenglases erfolgt im liquiden, niedrigviskosen Zustand, der gekennzeichnet ist durch eine Viskosität im Bereich von 10¹ dPa s bis 10⁴ dPa s , bevorzugt durch eine Viskosität im Bereich von 10² dPa s bis 10³ dPa s. Dieser Viskositätsbereich stellt sich typischerweise beim Multikomponentenglas bei Temperaturen im Bereich von 900°C bis 1500°C ein. Die Messung der Viskosität erfolgt mittels Scher- oder Rotationsviskosimetrie gemäß DIN ISO 7884-2 (1998).

Anstelle in der Exponentialschreibweise werden Viskositätswerte häufig auch anhand des dekadischen Logarithmus in der Form Ig(dPa·s) angegeben.

### Schlieren

Schlieren sind räumlich begrenzte Schwankungen der stofflichen Homogenität in einem Glas, die einen lokalen Brechwertunterschied bedingen. Die Abmessungen sind kurzreichweitig und liegen im Bereich von ca. 0,1mm bis ca. 2mm. Brechwertunterschiede (optische Gangunterschiede) machen sich in der Regel erst ab 30nm visuell bemerkbar..

Schlieren sind somit als optisches Merkmal charakterisierbar. Die Gießschliere, die an der Vereinigungsstelle der Teilströme auftritt, ist die Gesamtheit einer Vielzahl kleiner Störstellen (Schlieren), die insgesamt eine Ausrichtung entlang des Radius des Glasrings haben. Die einzelnen Schlieren haben eine kleine Ausdehnung in Umfangsrichtung, aber in ihrer Gesamtheit eine vergleichsweise großflächige Ausdehnung bis hin zu den äußeren Rändern des Glasrings.

Zur optischen Identifikation von Schlieren an der Position der Gießschliere eignet sich die Schattenmethode, wie beschrieben in der Broschüre "Technical information for optical devices TIE-25: Striae in optical glass" der Schott AG aus Juni 2006..

### Messung der Trockenätzbeständigkeit

Zur Messung der Trockenätzbeständigkeit wird eine Probe des Multikomponentenglases in einem RIE-Plasmareaktor einer Standard-Trockenätzprozedur mit folgenden Behandlungsschritten unterzogen:
(a) Eine Planseite der Messprobe wird poliert, so dass sie eine Oberflächenrauigkeit mit einem Rₐ-Wert von 4 nm oder weniger aufweist.
(b) Eine Teilfläche der polierten Planseite wird mit einem Lack maskiert.
(c) Die polierte Planseite wird einer Trockenätzprozedur ausgesetzt, die durch folgende Parameter charakterisiert ist:
   - In die HF-Energiequelle wird eine Leistung von 600 Watt eingespeist.
   - Mittels der HF-Energiequelle wird bei einer Eingangsleistung von 10 Watt an der Messprobe eine Vorspannung von minus 100 Volt angelegt-
   - Folgende Prozessgase werden in die Reaktorkammer eingeleitet: 5 sccm Argon, 1 sccm CF₄, 0,3 sccm O₂.
   - Der Kammerdruck ist auf 6 Pa eingestellt.
   - Die Ätzdauer beträgt 60 Minuten.

Bei einer Ätzrate von weniger als 50% im Vergleich zu einer Referenzprobe aus synthetischem Quarzglas ("Suprasil"; Handelsbezeichnung der Heraeus Quarzglas GmbH & Co. KG) wird das Multikomponentenglas als trockenätzbeständig eingestuft.

### Reinheit

Ein Multikomponentenglas wird hier als "hochrein" definiert, wenn der Anteil an Verunreinigungen an Cr, Mn, Fe, Co und Ni und Verbindungen für jedes einzelne dieser Elemente im Multikomponentenglas weniger als 50 Gew.-ppm beträgt, und wenn die Summe der Verunreinigungen an Cr, Mn, Fe, Co und Ni weniger als 100 Gew.-ppm beträgt.

### Ausführungsbeispiel

Nachfolgend wird die Erfindung anhand eines Ausführungsbeispiels und einer Zeichnung näher erläutert. Im Einzelnen zeigt in schematischer Darstellung
**Figur 1** eine auf einem Gestell montierte Gießform zur Herstellung eines Glasrings in einer dreidimensionalen Ansicht,
**Figur 2** einen Ausschnitt von Gießform und Gestell in einer Seitenansicht im Schnitt entlang der Linie A-A' von Figur 1,
**Figur 3** eine Skizze zur Erläuterung von Höhenebenen und Neigung der Gießform,
**Figur 4** eine Skizze zur Erläuterung von Auftreffzone und Vereinigungszone beim Gießen eines Glasrings,
**Figuren 5 bis 12** Skizzen zur Erläuterung von Verfahrensschritten zur Herstellung des Glasrings.

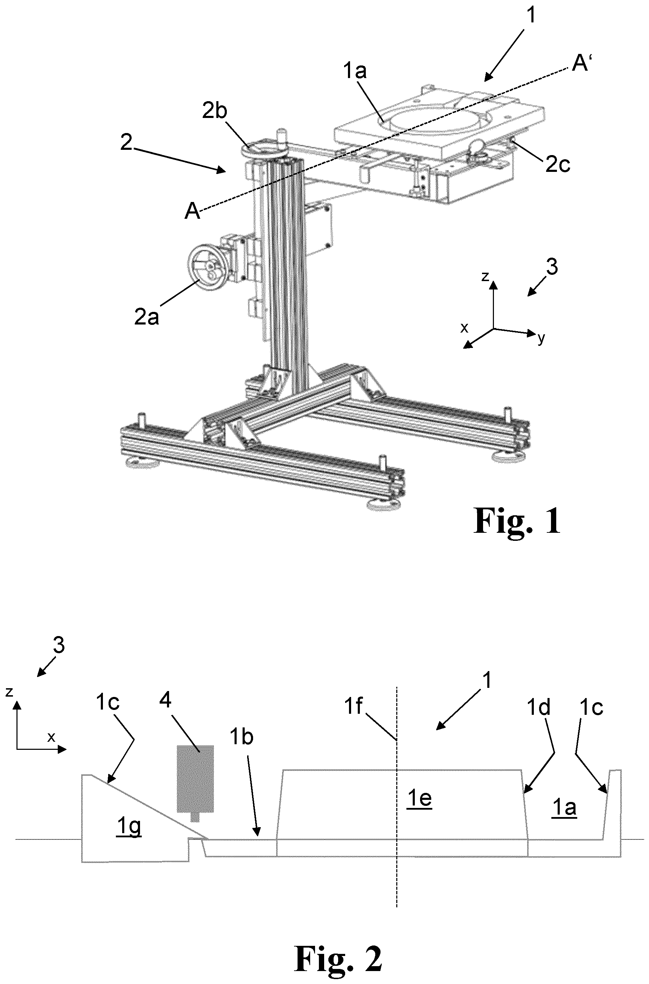

**Figur 1** zeigt schematisch eine Ausführungsform der Vorrichtung der Erfindung mit einer Gießform 1, die auf einem Gestell 2 montiert ist. Das Gestell 2 ist mit einer Lineareinheit 2a zur Positionierung der Gießform 2 in Höhenrichtung (z-Richtung) und einer weiteren Lineareinheit 2b zur translatorischen Bewegung der Gießform 2 innerhalb einer Ebene (in x-Richtung) ausgestattet. Weiterhin verfügt das Gestell 2 über ein elektrisch bewegbares Gelenk 2c zur Einstellung der Neigung der Gießform 1. Die Richtungen zeigt das Koordinatenkreuz 3 an. Die Bewegungen der Gießform 1 mittels der Lineareinheiten 2a, 2b und die Verkippung der Gießform 1 durch das Gelenk 2c erfolgen computergesteuert.

Die Vorrichtung dient zur Herstellung eines Glasrings aus einem hochreinen Multikomponentenglas durch Gießen einer Glasschmelze in die Gießform 1. Die Gießform 1 hat einen kreisrunden, geschlossenen Gießraum 1a, der nach oben hin offen ist. Oberhalb des Gießraums 1a ist ein Auslaufrohr 4 (Figur 2) positioniert, das ortsfest ist. Dem Auslaufrohr 4 wird Glasschmelze aus einem üblichen Schmelztiegel (nicht dargestellt) zugeführt.

Weitere Details der Gießform 1 sind aus **Figur 2** ersichtlich. Der Gießraum 1a hat gegenüberliegend der Spaltöffnung einen kreisringförmigen Gießraumboden 1b, der nach außen von einer ringförmigen Außenwand 1c und nach innen von einer Innenwand 1d begrenzt ist. Der Außendurchmesser des Gießraums 1a beträgt 360mm, der Innendurchmesser 300mm und die Höhe beträgt 30mm.

Die Innenwand 1d wird von einem Einsatzkörper 1e gebildet, der sich nach oben hin leicht konisch verjüngt. Der Einsatzkörper 1e verschließt während des Gießvorgangs eine Mittenöffnung der Gießform 1, die koaxial zur Mittelachse 1f verläuft. Nach dem Gießvorgang wird er nach unten (y-Richtung) aus der Mittenöffnung herausgeschoben.

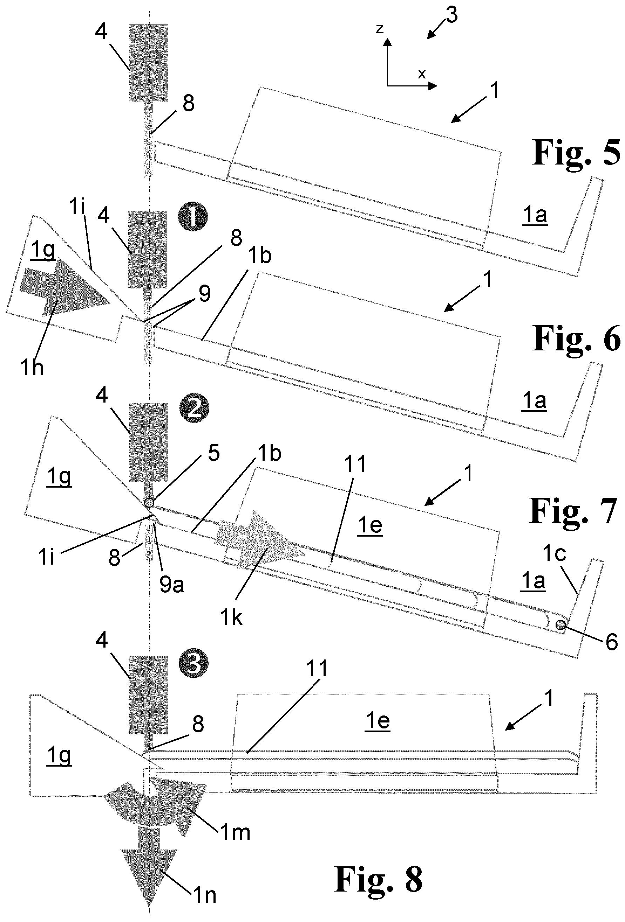

Ein Teil der Außenwand 1c beziehungsweise ein Teil des Gießraumbodens 1b wird von einem in radialer Richtung verschiebbaren (x-Richtung), keilförmigen Körper 1g gebildet, der vor dem Gießvorgang so angeordnet, dass er einen Gießspalt zur Gießform 1 freilässt. Die Funktionen des keilförmigen Körpers 1g und des Gießspalts werden weiter unten anhand des Verfahrens und der Figuren 6 bis 12 noch näher erläutert.

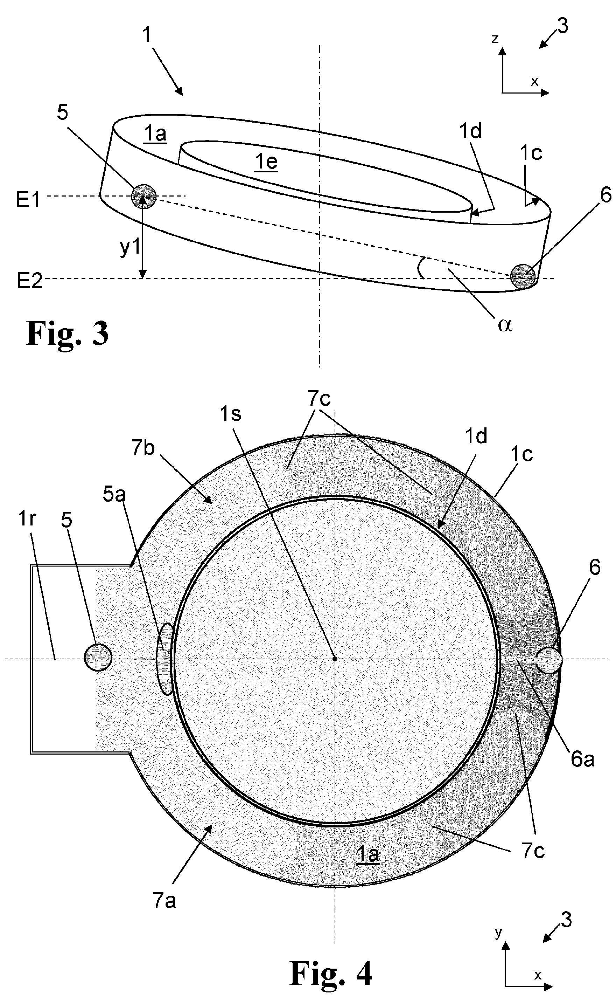

Die Gießform 1 ist zu Beginn des Gießvorgangs so im Raum orientiert, dass der Gießraumboden 1b eine Neigung in Bezug zur Horizontalen hat. Dies ist in der Skizze von **Figur 3** anhand des Verkippungswinkels α angedeutet.

Die Gießform 1 wird so unter dem Auslaufrohr 4 (Figur 2) positioniert, dass sich eine anfängliche Auftreffzone 5 des Gießstrangs in der Höhenebene E1 ergibt. Von dort fließt der Gießstrang in den Gießraum 1b ab und gelangt an die Gießraum-Innenwand 1d, die quasi als "Wasserscheide" für die Glasschmelze wirkt, so dass sich der Gießstrang in einen rechten Teilstrom 7a und in einen linken Teilstrom 7b aufteilt. Diese schematisch angedeutete Teilungszone 5a liegt im Bereich des Schnittpunkts der Gießraum-Innenwand 1d mit der in der Draufsicht von Fig. 4 eingezeichneten Mittellinie 1r der Gießform 1. Die beiden Teilströme 7a; 7b fließen im Gießraum 1b entsprechend dessen Neigung nach unten ab und vereinigen sich in einer Vereinigungszone 6, die in einer Höhenebene E2 liegt. Die Auftreffzone 5, die Teilungszone 5a, die Vereinigungszone 6 und die senkrecht zur Blattebene verlaufende Mittelachse 1s der Gießform 1 liegen dabei auf der Mittellinie 1r. Mit der Zeit füllt sich der Gießraum 1a mit Glasschmelze auf, wobei sich im Bereich der Vereinigungszone 6 eine Gießschliere 6a bildet. In der Gießschliere 6a sind kleine Störstellen, wie etwa kleinere Schlieren, zu erkennen. Die Gießschliere 6a bildet die visuell erkennbare Gesamtheit dieser kleineren Schlieren.

Die anfängliche Neigung des Gießraumbodens 1b beträgt im Ausführungsbeispiel 15 Winkelgrade und ergibt bei einem Abstand von 370mm zwischen Auftreffzone 5 und Vereinigungszone 6 einen Höhenunterschied y1 zwischen der Höhenebene E1 am erhöhten Ende des Gießraumbodens 1b und der Höhenebene E2 am gegenüberliegenden Ende des Gießraumbodens 1b von etwa 61mm.

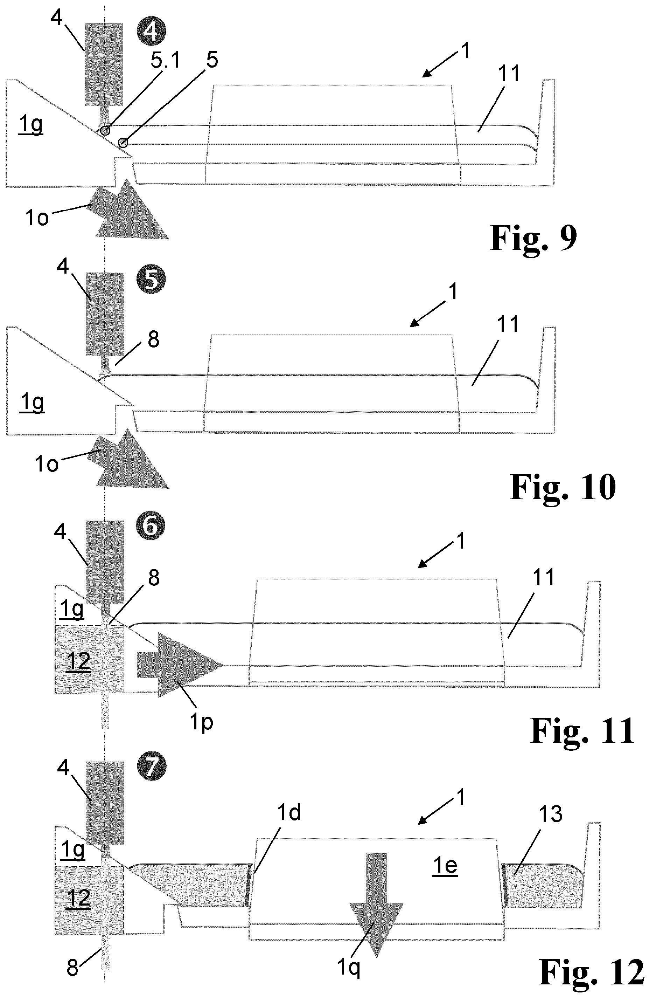

Nachfolgend wird das erfindungsgemäße Verfahren anhand der Figuren 1 bis 12 an einem Beispiel näher erläutert:
Der durch Gießen herzustellende Glasring 13 (Figur 12) hat einen Außendurchmesser von 360mm, einen Innendurchmesser von 300mm, demnach eine Wandstärke von 30mm und eine Höhe 25mm. Der Gießraum 1a der Gießform 1 ist dementsprechend ausgebildet.

In einem Schmelztiegel wird eine Glasschmelze mit folgender Zusammensetzung erschmolzen:

| **Komponente** | **Anteil (Mol%)** |
|---|---|
| SiO₂ | 57 |
| Al₂O₃ | 15 |
| Y₂O₃ | 10 |
| MgO | 18 |

Bei der Schmelztemperatur von etwa 1380°C hat das Glas eine Viskosität von etwa 100 dPa·s

**Figur 5** zeigt schematisch die Gießform 1, das Auslaufrohr 4 und einen aus dem Auslaufrohr 4 in vertikaler Richtung an der Gießform 1 vorbei ausfließenden Gießstrang 8. Die Gießform 1 hat anfänglich eine Neigung gegenüber der Horizontalen von 15 Grad. Es wird abgewartet, bis sich ein stabiler Strahl mit einem Durchsatz von 1000ml/min einstellt. Die dabei abfließende Glasmasse wird in einem Gefäß aufgefangen.

**Figur 6** zeigt schematisch einen Verfahrensschritt (1), in dem ein Keil 1g in radialer Richtung an den Gießstrang 8 herangeschoben wird, wie vom Richtungspfeil 1h angedeutet. Die der Gießform 1 zugewandte Oberseite des Keils 1g bildet eine in Richtung auf die Gießform 1 abfallende Rampe 1i. Der Gießstrang 8 fällt zunächst weiterhin durch einen Gießspalt 9, der zwischen der Rampe 1i und dem Gießraumboden 1b der Gießform 1 ausgebildet ist.

**Figur 7** zeigt einen Verfahrensschritt (2), in dem die Rampe 1i durch weiteres Heranschieben des Körpers 1g schließlich den Gießspalt 9 verschließt und dadurch den Gießstrang 8 unterbricht. Dieser trifft auf der Rampe 1i (Fig. 6) im Bereich einer anfänglichen Auftreffzone 5 auf und wird von dort auf den Gießraumboden 1b (Fig. 4) umgelenkt, wie vom Richtungspfeil 1k angedeutet. Damit beginnt eine erste Gießphase. Dabei trifft der vertikale Gießstrang 8 auf die anfängliche Auftreffzone 5 in der Höhenebene E1, teilt sich in der Teilungszone 5a in zwei Teilströme 7a, 7b auf (Figur 4), die den Einsatzkörper 1e umfließen und sich im Bereich der Vereinigungszone 6 in der niedrigeren Höhenebene E2 unter Ausbildung der Gießschliere 12 wieder vereinigen.

Die anfängliche Auftreffzone 5 liegt auf der Oberfläche des Keils 1i, der eine nach unten geneigte Rampe für die in die Form ausfließende Glasschmelze 11 mit einer Neigung von 30 Winkelgraden gegenüber dem Gießform-Boden bildet. Zusammen mit dem Neigungswinkel von 15 Winkelgraden durch die anfängliche Neigung des Gießform-Bodens 1b ergibt sich für den Gießstrang 8 an der anfänglichen Auftreffzone 5 somit eine gegenüber der Horizontalen um 45 Winkelgrade nach unten geneigte Auftrefffläche.

Die Glasschmelze 11 kühlt an den Wandungen des Gießraums 1a ab - insbesondere am Gießraumboden 1b - und erstarrt. Beim weiteren Auffüllen des Gießraums 1a bewegt sich eine - in Figur 4 durch bogenförmige Graubereiche angedeutete - Schmelzwalze 7c, die sich über die gesamte Breite des Gießraums 1a erstreckt, kontinuierlich und mit etwa konstanter Geschwindigkeit über die bereits erstarrte Schmelze hinweg immer weiter in Richtung der Vereinigungszone 6. Eine möglichst gleichmäßige Übereinanderschichtung der Glasschmelze vermeidet Konvektionen und damit einhergehende Schlieren.

Sobald der Gießraumboden 1b vollständig mit erstarrter Glasschmelze bedeckt ist, führt dies zur Vereinigung der beiden Schmelzwalzen 7c in der Vereinigungszone 6. Zur Verringerung der Bewegungsgeschwindigkeit der Schmelzwalze 7c wird die Neigung des Gießraumbodens 1b gegenüber der Horizontalen kontinuierlich um etwa 15 Grad/min verringert.

Dadurch wird im Verfahrensschritt (3), die Gießform 1 allmählich in eine horizontale Orientierung gebracht, wie dies der Richtungspfeil 1m in **Figur 8** schematisch zeigt, und eine zweite Gießphase beginnt. Der Drehpunkt der Kippbewegung ist ortsfest und liegt im Austrittsbereich des Auslaufrohres 4.

Gleichzeitig wird die Gießform 1 gegenüber dem ortsfesten Auslaufrohr 4 nach unten kontinuierlich mit einer Geschwindigkeit von etwa 15mm/min abgesenkt, wie der Richtungspfeil 1n andeutet, und entlang des Konturverlaufs der Rampe so bewegt, dass das Auslaufrohr 4 einen weitgehend konstanten Abstand von etwa 3 bis 5 mm zum Niveau der Glasschmelze 11 einhält.

**Figur 9** zeigt schematisch einen Verfahrensschritt (4), in dem die Gießform 1 mitsamt des Gießraumbodens 1b (Fig. 4) eine horizontale Orientierung erreicht haben. Die Glasschmelze 11 im Bereich der anfänglichen Auftreffzone 5 ist auf eine Temperatur unterhalb der Erweichungstemperatur des Glases abgekühlt, und wird von weiterer, niedrigviskoser Glasschmelze 11 überflutet, so dass sich eine horizontale Schmelzoberfläche bildet. Durch das kontinuierliche Absenken der Gießform 1 gegenüber dem Auslaufrohr 4 (Richtungspfeil 1n in Fig. 8) und durch sukzessive translatorische Verschiebung der Gießform 1 wie vom Richtungspfeil 1o angezeigt, hat sich eine neue Auftreffzone 5.1 für den Gießstrang 8 ergeben, die weiterhin im etwa gleichen Abstand über der Rampe 1i des keilförmigen Körpers 1g liegt. Die neue Auftreffzone 5.1 befindet sich dabei permanent am Rand des sich bildendenden Glasrings, so dass die Fließrichtung der Glasschmelze 11 stets in Richtung der Formmitte gerichtet ist, beziehungsweise allenfalls zur Seite umgelenkt wird, aber keine Glasschmelze in die Gegenrichtung fließt.

Der Gießvorgang wird so lange fortgesetzt bis die Glasschmelze 11 den Gießraum 1 soweit aufgefüllt hat, dass die Höhe des herzustellenden Glasrings 13 (Figur 12) erreicht ist. Diesen Zustand (Verfahrensschritt (5)) zeigt **Figur 10****.**

Der anschließende Verfahrensschritt (6) kann als dritte Gießphase bezeichnet werden, in welcher das Ende des Gießprozesses eingeleitet wird, indem der weiterhin aus dem Auslaufrohr 4 auslaufende Gießstrang 8 wieder von der Rampe des Einsatzkörpers 1g weggeleitet wird, indem der keilförmige Körper 1g mitsamt der restlichen Gießform 1 - wie in **Figur 11** vom Richtungspfeil 1p angezeigt - so verschoben wird, dass er in den Bereich einer Aussparung 12 am Einsatzkörper 1g gelangt und vertikal nach unten in das Sammelgefäß fällt.

Die anhand der Figuren 5 bis 11 erläuterten Bewegungen der Gießform 1 und des keilförmigen Körpers 1g in den Verfahrensschritten (1) bis (6) werden rechnergesteuert ausgeführt.

Im Verlauf der weiteren Abkühlung der Glasschmelze 11 wird der konische Einsatzkörper 1e um einige Millimeter abgesenkt (Verfahrensschritt (7)), wie dies der Richtungspfeil 1q der **Figur 12** andeutet. Dadurch wird ein "Aufschrumpfen" des heißen Glasrings 13 auf die Innenwand 1d vermieden.

Der danach erhaltene ringförmige Glas-Rohling13 wird spannungsfrei getempert und auf die Soll-Abmessungen des Glasrings geschliffen, wobei diese durch bereits durch die endkonturnahe Formung im Gießprozess nahezu erreicht sind.

So wird ein Glasring aus hochreinem Multikomponentenglas erhalten, der sich durch hohe Transparenz, hohe Reinheit und hohe Plasmabeständigkeit auszeichnet.

Die hohe Reinheit des Multikomponentenglases zeigt sich darin, dass der Anteil an Verunreinigungen an Cr, Mn, Fe, Co und Ni und Verbindungen für jedes einzelne dieser Elemente im Multikomponentenglas weniger als 50 Gew.-ppm beträgt, und dass die Summe der Verunreinigungen an Cr, Mn, Fe, Co und Ni weniger als 100 Gew.-ppm beträgt.

Die hohe Plasmabeständigkeit des Multikomponentenglases zeigt sich darin, dass es bei Durchführung der Standard-Trockenätzprozedur eine Ätzrate aufweist, die weniger als 25% der Ätzrate von synthetisch erzeugtem Quarzglas (Suprasil) beträgt.

Der Glasring zeigt eine charakteristische Gießschliere 6a (Figur 4), die sich über einen teilweisen oder über den gesamten Querschnitt (die gesamte Breite und die gesamte Höhe) des Glasrings im Bereich der vormaligen Vereinigungszone 6 erstreckt. Die Gießschliere 6a hat in Umfangsrichtung eine Ausdehnung von weniger als 2mm und bewirkt im Multikomponentenglas für einen Messstrahl mit einer Messwellenlänge von 535nm im Mittel einen Gangunterschied von mehr als 30nm. Sie kann als Positionsmarkierung in einer Anlage dienen, wie beispielsweise einer Plasma-Ätzanlage für Halbleiter.

## Patentansprüche

1. Verfahren zur Herstellung eines Glasrings aus Multikomponentenglas, **dadurch gekennzeichnet, dass** ein ringförmiger Rohling aus dem Multikomponentenglas anhand eines Gießvorgangs erzeugt wird, der die folgenden Verfahrensschritte umfasst:
(a) Bereitstellen einer Gießform (1) mit einem um eine Mittelachse (1s) umlaufenden, ringförmigen Gießraum (1a) mit einer Gießraumhöhe, der einen von Innenwand (1d) und Außenwand (1c) begrenzten Gießraumboden (1b) und diesem gegenüberliegend eine Gießraumöffnung aufweist,
(b) Erzeugen einer Glasschmelze des Multikomponentenglases,
(c) Einlassen eines Gießstrangs (8) der Glasschmelze in die Gießform (1), wobei der Gießstrang (8) auf einer Auftreffzone (5; 5.1) auftrifft, und in einen rechten Teilstrom (7a) und in einen linken Teilstrom (7b) divergiert, und dass die Teilströme (7a; 7b) an einer Vereinigungszone (6) im Gießraum (1a) zusammenfließen und dabei den Gießraum (1a) über mindestens einen Teil der Gießraumhöhe auffüllen.
(d) Abkühlen der im Gießraum (1a) enthaltenen Glasschmelze unter Ausbildung eines ringförmigen Rohlings (13) und Weiterberarbeitung des ringförmigen Rohlings (13) zum Glasring.

2. Verfahren nach Anspruch 1, **dadurch gekennzeichnet, dass** die Auftreffzone auf einer oberen Höhenebene E1 liegt, und dass die Vereinigungszone auf einer unteren Höhenebene E2 liegt, wobei vorzugsweise die Gießform so orientiert wird, dass der Gießraumboden eine Neigung gegenüber der Horizontalen zwischen den Höhenebenen E1 und E2 aufweist, wobei die Neigung während des Gießvorgangs verändert wird.

3. Verfahren nach Anspruch 2, **dadurch gekennzeichnet, dass** die Position der Auftreffzone während einer ersten Gießphase im Bereich einer von außen nach innen abfallenden Rampe liegt, und dass während einer zweiten Gießphase die Position der Auftreffzone auf der Rampe verändert, vorzugsweise nach außen verlagert wird, wobei vorzugsweise die Gießform während der zweiten Gießphase abgesenkt wird.

4. Verfahren nach Anspruch 3, **dadurch gekennzeichnet, dass** die Rampe geöffnet und geschlossen werden kann, wobei der Gießstrang durch Schließen der Rampe abgeschnitten und von einer vertikalen Fallrichtung auf den Gießraumboden umgelenkt wird.

5. Verfahren nach einem oder mehreren der vorhergehenden Ansprüche, **dadurch gekennzeichnet, dass** der Gießstrang auf einen Durchsatz von im Bereich von 150 ml/min bis 3000 ml/min, bevorzugt im Bereich 300 ml/min bis 1500 ml/min, dosiert wird.

6. Verfahren nach einem oder mehreren der vorhergehenden Ansprüche, **dadurch gekennzeichnet, dass** die Glasschmelze auf eine Einspeiseviskosität im Bereich von 10 bis 10000 dPa s, besonders bevorzugt im Bereich von 100 bis 1000 dPa s konditioniert wird.

7. Vorrichtung zur Herstellung eines Glasrings aus Glas durch Gießen einer Glasschmelze, aufweisend:
(a) eine Gießform mit einem um eine Mittelachse umlaufenden, ringförmigen Gießraum mit einer Gießraumhöhe, der einen von Innenwand und Außenwand begrenzten Gießraumboden und diesem gegenüberliegend eine Gießraumöffnung aufweist, und
(b) einen Auslauf zum Zuführen einer Schmelze des Glases zu der Gießform, **dadurch gekennzeichnet, dass** die Vorrichtung eine Bewegungseinheit zur räumlichen Bewegung des Auslaufs und/oder der Gießform aufweist, mittels der die Gießform relativ zum Auslauf bewegbar und so positionierbar ist, dass ein aus dem Auslaufrohr austretender Gießstrang an einer Auftreffzone auftrifft und in einen rechten Teilstrom und in einen linken Teilstrom divergiert, und die Teilströme an einer Vereinigungszone im Gießraum zusammenfließen.

8. Vorrichtung nach Anspruch 7, **dadurch gekennzeichnet, dass** die Bewegungseinheit zum Einstellen einer Neigung der Gießform gegenüber der Horizontalen ausgelegt ist derart, dass die Auftreffzone in einer oberen Höhenebene E1 liegt, und das die Vereinigungszone in einer unteren Höhenebene E2 liegt.

9. Vorrichtung nach Anspruch 7 oder 8, **dadurch gekennzeichnet, dass** die Bewegungseinheit zum Absenken der Gießform relativ zum Auslauf ausgelegt ist.

10. Vorrichtung nach Anspruch 9, **dadurch gekennzeichnet, dass** der Gießraumboden eine Rampe mit einer Öffnung aufweist, die mittels eines beweglichen Schiebers verschließbar ist.

11. Glasring aus Multikomponentenglas, der eine Mittellinie und einen Querschnitt aufweist, der definiert ist von einer Oberseite, einer dieser gegenüber liegenden Unterseite, einer Außenwand und einer Innenwand, und der an einer azimutalen Position eine radiale Gießschliere aufweist, die sich - bezogen auf die Mittellinie - in radialer Richtung im Bereich zwischen Innenwand und Außenwand erstreckt.

12. Glasring nach Anspruch 11, **dadurch gekennzeichnet, dass** die Gießschliere den Querschnitt zwischen Oberseite, Unterseite, Außenwand und Innenwand vollständig ausfüllt.

13. Glasring nach Anspruch 11 oder 12, **dadurch gekennzeichnet, dass** die Gießschliere für einen Messtrahl einer Wellenlänge von 535nm einen Gangunterschied von mindestens 30nm erzeugt.

14. Glasring nach einem oder mehreren der Ansprüche 11 bis 13, **dadurch gekennzeichnet, dass** er einen Außendurchmesser im Bereich von 300 bis 500mm und eine Wanddicke von mindestens 10mm aufweist.

15. Glasring nach einem oder mehreren der Ansprüche 11 bis 14, **dadurch gekennzeichnet, dass** der Anteil an Verunreinigungen an Cr, Mn, Fe, Co und Ni und Verbindungen für jedes einzelne dieser Elemente im Multikomponentenglas weniger als 50 Gew.-ppm und besonders bevorzugt weniger als 20 Gew.-ppm beträgt, und dass die Summe der Verunreinigungen an Cr, Mn, Fe, Co und Ni weniger als 100 Gew.-ppm beträgt.
